# EUROPEAN PATENT SPECIFICATION

(11) **EP 4 505 270 B1**
(45) Date of publication and mention of the grant of the patent: **14.01.2026**
(21) Application number: 23728174.6
(22) Date of filing: 03.05.2023
(51) Int. Cl.: G06F 1/16

(54) **MAGNETIC DOCKING**
MAGNETISCHE ANDOCKUNG
CONNEXION MAGNÉTIQUE

(30) Priority: 10.05.2022 US 202263364479 P
(43) Date of publication of application: 12.02.2025
(73) Proprietor: Google LLC, Mountain View, CA 94043 (US)
(72) Inventor: WONG, Wing Tung, Mountain View, California 94043 (US); CHERN, Wenson, Mountain View, California 94043 (US); GRAVES, Ethan, Mountain View, California 94043 (US); SAINI, Vivek, Mountain View, California 94043 (US); DE LA FUENTE, Valentin Shaun, Mountain View, California 94043 (US); FANTIN, Juan Manuel, Mountain View, California 94043 (US); CHANG, David F., Mountain View, California 94043 (US); PATEL, Prashant Bhogilal, Mountain View, California 94043 (US); BRUMMER, Bengt Gunnar, Mountain View, California 94043 (US); PI, Jason Stanley, Mountain View, California 94043 (US); WONG, Amy Lai, Mountain View, California 94043 (US)
(74) Representative: Maikowski & Ninnemann Patentanwälte Partnerschaft mbB
(86) International application number: PCT/US2023/020842
(87) International publication number: WO 2023/219850

(56) References cited:
- EP-A1- 3 579 374
- WO-A2-2011/156768
- US-A1- 2012 206 088

## Description

### CROSS-REFERENCE TO RELATED APPLICATIONS

This PCT Patent Application claims priority to and the benefit of U.S. Provisional Patent Application No. 63/364,479, entitled "DOCKABLE AND UNDOCKABLE MULTI-PURPOSE ELECTRONIC TABLET DEVICE," filed May 10, 2022.

### BACKGROUND

Electronic tablet devices have become increasingly popular devices due to their larger display screens and touch-input capabilities. However, challenges arise when a user sets the tablet device on a surface but wishes to continue interacting with the device to consume media content. Due to their form factor, tablet devices are generally designed to lie on a flat surface, which enables the user to view the display by looking downward. If the user wishes to set the tablet device on the kitchen counter, for example, to view a recipe or watch a basketball game while preparing a meal, challenges arise is stabilizing the device in an upright position such that the display screen is substantially vertical relative to the counter.

Tablet computing devices, sometimes referred to as tablets or as tablet computers, are generally planar, lightweight devices that include a touch-screen display. Tablets are battery powered and can be plugged in to recharge the tablet's battery.

EP 3 579 374 A1 relates to a stand comprising: a stand housing; a wireless power transmission member disposed in the internal space of the stand housing; and at least one magnet disposed near the wireless power transmission member, wherein the stand is coupled to the outer surface of an electronic device in such a manner that at least one attachment member disposed in a corresponding position in the internal space of the electronic device is attached thereto by the magnetic force of the magnet, and supplies wireless power to the electronic device via the wireless power transmission member. Other various embodiments are possible.

WO 2011/156768 A2 relates to systems and methods for providing multi-protocol operation and maximum interoperability between chargers and receivers of wireless power. Further, methods for use of magnets in or around magnetically sensitive devices such that the operation of such a device is not impaired are discussed. Applications in various devices and systems are described. In particular, applications for fastening mobile devices to their cases or other surfaces, and also alignment or attachment for power transfer or charging are described. Also described herein are systems and methods for the use of multi-pole and other magnets, in electronic and other articles, devices, components, or parts thereof.

### SUMMARY

The present document describes techniques for a dockable and undockable multiple-purpose electronic tablet device. These techniques enable a tablet device, operable in tablet device mode, to be docked to a base, which secures the tablet device in an upright position for substantial horizontal viewing of a display screen of the tablet device. The tablet device is also electrically couplable to the base to enable communication between the tablet device and the base and to enable power transfer from the base to the tablet device for charging a battery of the tablet device.

In aspects, the tablet device includes electrical contacts (e.g., pogo pads) on a rear surface, which is opposite a display screen of the tablet device. When docked to the base, the electrical contacts electrically couple to corresponding receptacle contacts on the base, forming a solid and physical connection that enables the transfer of electrical current and electrical signals. The electrical contacts may be positioned at any suitable location on the rear surface, which enables the electrical contacts to couple to (e.g., mate with) the corresponding receptacle contacts on the base.

The tablet device may be docked (e.g., mounted, coupled, secured) to the base via a coupling mechanism, which may include a magnetic coupling mechanism or a mechanical coupling mechanism. For example, magnets may be implemented in the base and/or the tablet device to generate a magnetic attraction force that securely connects and holds the tablet device to the base. With sufficient counter force (e.g., pull) applied by a user, the tablet device can decouple from the base.

The tablet device and the base together form a modular system. In one example, the base may include an audio output device (e.g., speaker) to provide audio output from the tablet device. Digital signals may be communicated from the tablet device to the base, via the electrical contacts and the corresponding receptacle contacts, and the base may correspondingly output audio signals via the audio output device. In this way, the tablet device and the base can communicate via a physical connection rather than via wireless communication (e.g., Bluetooth^{™}). However, in some implementations, the tablet device may communicate with the base via a wireless communication.

A tablet computer system, according to at least some embodiments of the present disclosure, includes a dock and a tablet computer which can be removably docked from the dock. The tablet computer includes an electronic display and an enclosure housing the electronic display. The tablet computer includes a first plurality of magnets that is arranged to magnetically couple with a second plurality of magnets of the dock. The first plurality of magnets is formed in an arrangement including at least four groups of magnets on each lateral side of the enclosure. The at least four groups of magnets on a first lateral side of the enclosure are in a mirrored configuration to the at least four groups of magnets on a second lateral side of the enclosure. At least three of the groups of magnets on each lateral side of the enclosure are oriented horizontally and a fourth group of magnets on each lateral side of the enclosure is oriented vertically. The three groups of magnets on each lateral side of the enclosure include alternating north and south polarity across the three groups of magnets and the two innermost groups of magnets include matching north and south polarities across the two innermost groups of magnets.

The tablet computer system may optionally include at least some of the following embodiments. The tablet computer system may further include a shunt coupled to one or more magnets to direct a magnetic field associated with the one or more magnets. A gap between first plurality of magnets and the second plurality of magnets may be in a range of 1.65 milimeters (mm) to 2.5 mm when the tablet computer is docked to the dock. The tablet computer system may further include a stimuli magnet on the enclosure for detecting tilt of the tablet computer. The tablet computer system may further include an additional group of magnets disposed along a longitudinal axis of the enclosure. The additional group of magnets may magnetically couple with a third plurality of magnets of an alternative dock. Each group of magnets may include two magnets. Magnets within each group of magnets may be arranged in opposing north and south polarities. Magnets within each group of magnets may be arranged such that opposite poles are oriented toward one another.

A tablet computer, according to at least some embodiments of the present disclosure, includes an electronic display and an enclosure housing the electronic display. The tablet computer includes a first plurality of magnets that is arranged to magnetically couple with a second plurality of magnets of a dock. The first plurality of magnets is formed in an arrangement that includes at least four groups of magnets on each lateral side of the enclosure. The at least four groups of magnets on a first lateral side of the enclosure are in a mirrored configuration to the at least four groups of magnets on a second lateral side of the enclosure. At least three of the groups of magnets on each lateral side of the enclosure are oriented horizontally and a fourth group of magnets on each lateral side of the enclosure is oriented vertically. The three groups of magnets on each lateral side of the enclosure include alternating north and south polarity across the three groups of magnets and the two innermost groups of magnets include matching north and south polarities across the two innermost groups of magnets.

The tablet computer may optionally include at least some of the following embodiments. The tablet computer may further include a shunt coupled to one or more magnets to direct a magnetic field associated with the one or more magnets. A gap between first plurality of magnets and the second plurality of magnets may be in a range of 1.65 mm to 2.5 mm when the tablet computer is docked to the dock. The tablet computer may further include a stimuli magnet on the enclosure for detecting tilt of the tablet computer. The tablet computer may further include an additional group of magnets disposed along a longitudinal axis of the enclosure. The additional group of magnets may magnetically couple with a third plurality of magnets of an alternative dock. Each group of magnets may include two magnets. Magnets within each group of magnets may be arranged in opposing north and south polarities.

A dock, according to at least some embodiments of the present disclosure includes a dock housing and a face plate. The face plate is removably coupled to a tablet computer. The dock includes a first plurality of magnets, wherein the first plurality of magnets is arranged to magnetically couple with a second plurality of magnets of the tablet computer. The first plurality of magnets is formed in an arrangement that includes at least four groups of magnets on each lateral side of the face plate. The at least four groups of magnets on a first lateral side of the face plate are in a mirrored configuration to the at least four groups of magnets on a second lateral side of the face plate. At least three of the groups of magnets on each lateral side of the face plate are oriented horizontally and a fourth group of magnets on each lateral side of the face plate is oriented vertically. The three groups of magnets on each lateral side of the face plate includes alternating north and south polarity across the three groups of magnets and the two innermost groups of magnets include matching north and south polarities across the two innermost groups of magnets.

The dock may optionally include at least some of the following embodiments. The dock may further include a shunt coupled to one or more magnets to direct a magnetic field associated with the one or more magnets. A gap between first plurality of magnets and the second plurality of magnets may be in a range of 1.65 mm to 2.5 mm when the tablet computer is docked to the dock. Each group of magnets may include two magnets. Magnets within each group of magnets may be arranged in opposing north and south polarities.

This summary is provided to introduce simplified concepts of a dockable and undockable multiple-purpose electronic tablet device, which is further described below in the Detailed Description. This summary is not intended to identify essential features of the claimed subject matter, nor is it intended for use in determining the scope of the claimed subject matter.

### BRIEF DESCRIPTION OF THE DRAWINGS

A further understanding of the nature and advantages of various embodiments may be realized by reference to the following figures. In the appended figures, similar components or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.
FIG. 1 illustrates an example implementation of a dockable and undockable multiple-purpose electronic tablet device;
FIG. 2 illustrates a front elevational view of the electronic device from FIG. 1.
FIG. 3A illustrates a top plan view of the electronic device from FIG. 1.
FIG. 3B illustrates a bottom plan view of the electronic device from FIG. 1.
FIG. 4 illustrates a rear elevational view of the electronic device from FIG. 1.
FIG. 5A illustrates a left elevational view of the electronic device from FIG. 1.
FIG. 5B illustrates a right elevational view of the electronic device from FIG. 1.
FIG. 6 illustrates a side view of an embodiment of a device that is magnetically docked with a dock, according to some implementations of the present disclosure.
FIG. 7A is a top cross-sectional view of an electronic device having an arrangement of magnets, according to some implementations of the present disclosure.
FIG. 7B illustrates an arrangement of magnets, according to some implementations of the present disclosure.
FIG. 7C illustrates an arrangement of magnets, according to some implementations of the present disclosure.
FIG. 8A is a top perspective cross-sectional view of a dock having an arrangement of magnets, according to some implementations of the present disclosure.
FIG. 8B illustrates an arrangement of magnets, according to some implementations of the present disclosure.
FIG. 9A illustrates a side view of an embodiment of a device that is magnetically docked with a dock, according to some implementations of the present disclosure.
FIG. 9B is a top cross-sectional view of a dock having an arrangement of magnets, according to some implementations of the present disclosure.
FIG. 10 is a flowchart of a method, according to some implementations of the present disclosure.

### DETAILED DESCRIPTION

Various embodiments are described related to an electronic device and a dock. The electronic device and the dock have corresponding sets of magnets which are arranged to optimize magnetically docking and undocking the electronic device (e.g., a tablet computer) from the dock. The electronic device may include a first set of magnets. The first set of magnets is arranged to magnetically couple with a second set of magnets of the dock.

Magnets may be used to couple and align a tablet computer to a charging dock. Magnets can be used for coupling two devices, such as coupling a tablet computer and a dock as detailed herein. The attractive force between magnets in the tablet computer and in the dock may need to be strong enough to couple the tablet computer to the dock and to prevent unwanted decoupling when the electronic device is accidentally hit or a surface that the dock is resting on is accidentally hit. For example, the magnets may be arranged and designed to counteract any shock impulses generated in a surface supporting the tablet dock system. The attractive force of the magnets may also need to be strong enough to resist tipping of the tablet computer and the dock or unwanted undocking of the tablet computer from the dock when a user interacts with a docked tablet computer.

When the tablet computer is mounted to the dock, a first plurality of magnets that are included within the tablet computer can magnetically couple with a second plurality of magnets present in the dock. The magnets can function to not only hold the tablet computer in position on the dock, but also cause multiple contact pads of the tablet computer to align with contact pins of the dock. The contact pads allow for electrical signals, which can include data, power, or both, to be exchanged between the dock and the tablet computer.

The embodiments detailed herein are focused on an electronic device and a dock having arrangements of magnets for enabling coupling of the electronic device and the dock. In some embodiments, the electronic device is a tablet computer that is a component of a tablet computer system. Specifically, a tablet computer can serve as a home assistant device and/or hub to manage smart home devices in an environment. The tablet computer may be able to record video, communicate with a remote server system, and interact with users via spoken communications. For example, a home assistant device may provide automated control or voice control of devices, appliances, and systems, such as heating, ventilation, and air conditioning ("HVAC") system, lighting systems, home theater, entertainment systems, as well as security systems. Smart home networks may include control panels that a person may use to input settings, preferences, and scheduling information that the smart home network uses to provide automated control of the various devices, appliances, and systems in the home. For example, the person may input a schedule indicating when the person is away from the home, and the smart home network uses this information along with information obtained from various devices in the home to detect unauthorized entry when the user is away. The tablet computer may be left docked with a dock to charge its battery and use other features of the dock, such as an integrated speaker. The tablet computer may be removed from the dock for convenience to be used or displayed at another location. When not in use (whether docked, not docked, or both), photos or photo albums selected by a user may be presented by the tablet.

Many other types of electronic devices can benefit from the optimized arrangement(s) of magnets described herein. For example, smartphones, gaming devices, e-readers, personal digital assistants (PDAs), digital paper tablets, and smart picture frames may benefit from various embodiments of a battery housing as detailed herein. Furthermore, the electronic device may an assistant device (e.g., Google^{®} Nest^{®} Hub; Google^{®} Nest^{®} Hub Max); a home automation controller (e.g., controller for an alarm system, thermostat, lighting system, door lock, motorized doors, etc.); a gaming device (e.g., a gaming system, gaming controller, data glove, etc.); a communication device (e.g., a smart phone such as a Google^{®} Pixel^{®} Phone, cellular phone, mobile phone, wireless phone, portable phone, radio telephone, etc.); and/or other computing device (e.g., a tablet computer, phablet computer, notebook computer, laptop computer, etc.).

The present document describes a dockable and undockable multiple-purpose electronic tablet device. The techniques described herein include an electronic device (e.g., tablet device) that can, when undocked, operate as a standalone computing device when undocked and when docked to a base, operate as a virtual-assistant device.

The tablet device may be a landscape-first tablet for docking purposes, such that the tablet device is oriented in a landscape orientation when docked with the base. Accordingly, the tablet device may have a landscape-first oriented feature arrangement. The tablet device includes electrical contacts (e.g., pogo pads) that are exposed to the environment and configured to physically connect with corresponding receptacle contacts on the base. Such a physical connection enables the tablet device to communicate with the base without wirelessly pairing with the base. Also, the tablet device may include abrasion feet, which significantly reduce slidable movement on a surface, particularly when the tablet device is docked to the base in an upright position (e.g., substantially vertical position with respect to a substantially horizontal surface).

While features and concepts of the described techniques for a dockable and undockable multiple-purpose electronic tablet device can be implemented in any number of different environments, aspects are described in the context of the following examples.

### Example System and Devices

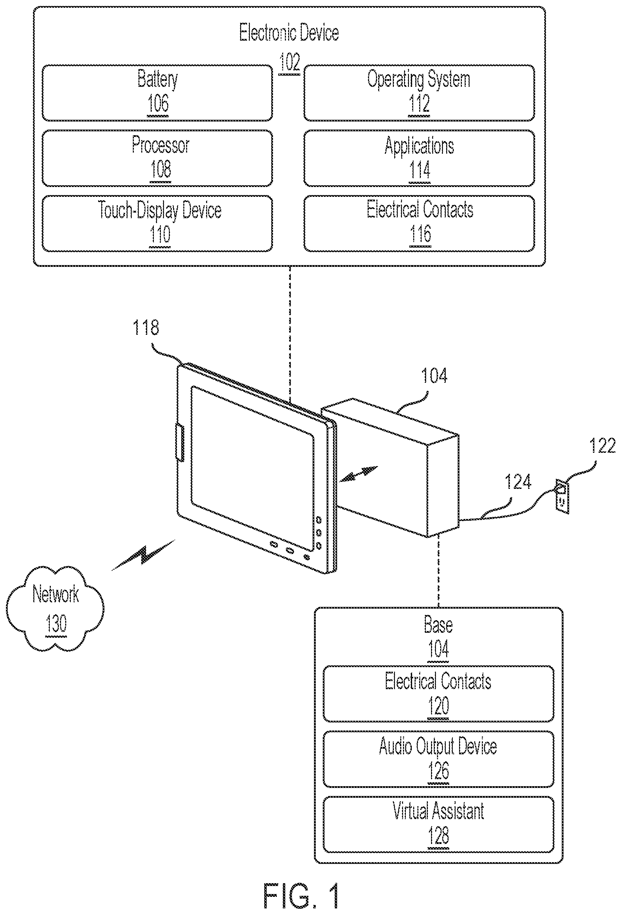

FIG. 1 illustrates an example implementation of a system 100 having a dockable and undockable multi-purpose tablet device. In the illustrated example, the system 100 includes an electronic device 102 and a base 104, which are couplable to one another. The base 104 not only supports the electronic device 102 in an upright position to enable a substantially horizontal viewing angle for a user, but the base 104 also provides additional functionalities to the electronic device 102. For example, the base 104 can be a battery charger for the electronic device 102, a speaker for the electronic device 102, a keyboard for the electronic device 102, a stand for the electronic device 102, a handheld controller for the electronic device 102, and so forth.

The electronic device 102 includes a variety of components that enable the electronic device 102 to operate as a mobile computing device, including a battery 106, one or more processors 108, a touch-sensitive display device 110 (e.g., an electronic display), and operating system 112, and applications 114. The electronic device 102 also includes electrical contacts 116, which enable the electronic device 102 to physically connect with another device, (e.g., the base 104). In some aspects, the electrical contacts 116 are exposed through a housing 118 of the electronic device 102 to enable coupling without requiring the user to first remove a covering. However, in some implementations, the electrical contacts 116 may have a covering for protection from the environment and the elements, including dust and water ingress.

The battery 106 may be any suitable rechargeable battery. An example battery 106 is a Li-ion battery. The touch-display device 110 is a touch-sensitive display configured to receive and detect touch input by the user. The touch-display device 110 is used to render digital content including media content (e.g., images, video).

The base 104 includes additional electrical contacts (e.g., corresponding receptacle contacts 120) configured to couple to the electrical contacts 116 on the electronic device 102 to provide a physical electrical connection for communication and power transfer. This physical connection between the electrical contacts 116 on the electronic device 102 and the corresponding receptacle contacts 120 on the base 104 enable the electronic device 102 and the base 104 to communicate with one another without requiring the user to connect (e.g., plug in) a cable between the electronic device 102 and the base 104 and without establishing a wireless connection between the electronic device 102 and the base 104.

The base 104 may be connected to an external power source 122 (e.g., direct current provided via an outlet) via one or more wires (e.g., power cord 124). Applications 114 and/or the operating system 112 are implemented as computer-readable instructions on computer-readable media (e.g., the storage media) and can be executed by the processor(s) 108 to provide some or all of the functionalities described herein. The computer-readable media provides data storage mechanisms to store various device applications 114, the operating system 112, memory/storage, and other types of information and/or data related to operational aspects of the electronic device 102. For example, the operating system 112 can be maintained as a computer application within the computer-readable media and executed by the processor(s) 108 to provide some or all of the functionalities described herein. The device applications 114 may include a device manager, such as any form of a control application, software application, or signal-processing and control modules. The device applications 114 may also include system components, engines, or managers to implement techniques for the dockable and undockable multiple-purpose electronic tablet device. The electronic device 102 may also include, or have access to, one or more machine-learning systems.

The base 104 may also include an audio output device 126 (e.g., speaker) configured to provide audio that is output by the electronic device 102. When the electronic device 102 is docked to the base 104, electronic device 102 can output audio via the audio output device 126, without wirelessly pairing (or having previously wirelessly paired) with the base 104 and/or the audio output device 126.

In aspects, the base 104 includes circuitry for implementing a voice-activated virtual assistant 128 capable of processing audio input from the user to identify a query or command and initiating a corresponding function, including providing audio output that responds to the query or command. The virtual assistant 128 may be used to perform a variety of tasks, including searching the Internet, scheduling events and alarms, controlling home automation, controlling internet-of-things (IoT) devices, and so on. The electronic device 102, when docked to the base 104, operates as the display for a user interface associated with the virtual assistant 128.

In implementations, the electronic device 102 and the base 104 form a modular system. For example, when the electronic device 102 is docked, the system operates as a virtual assistant with the user interface displayed via the electronic device 102 and audio output by the base 104. When the electronic device 102 is undocked, the electronic device 102 operates as a standalone tablet device.

The electronic device 102 may also be configured to communicate with one or more devices or servers over a network (e.g., network 130). By way of example and not limitation, the electronic device 102 may communicate data over a local-area-network (LAN), a wireless local-area-network (WLAN), a personal-area-network (PAN), a wide-area-network (WAN), an intranet, the Internet, a peer-to-peer network, point-to-point network, or a mesh network.

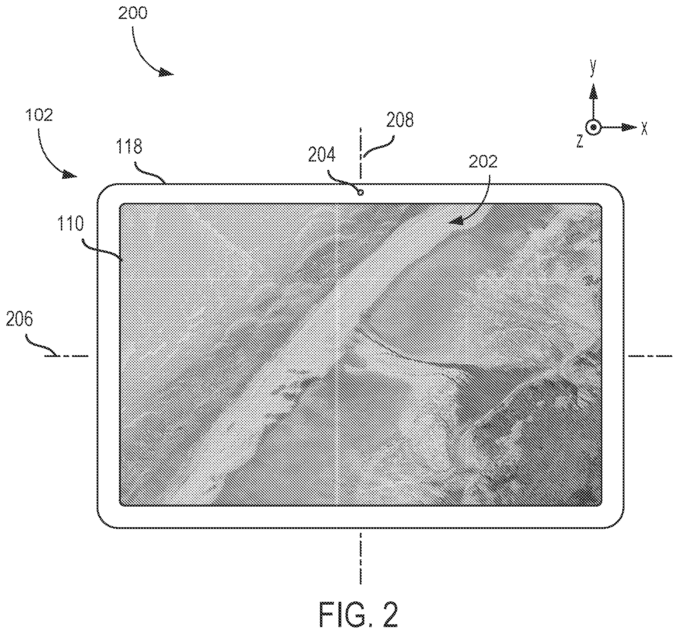

FIG. 2 illustrates a front elevational view 200 of the electronic device 102 from FIG. 1. As illustrated, the electronic device 102 includes the touch-display device 110. The touch-display device 110 defines a front surface 202 of the electronic device 102, which is substantially planar. The housing 118 includes a bezel around the touch-display device 110. The electronic device 102 also includes a first camera 204 (e.g., front camera) positioned within (internally) the housing 118 and facing a direction substantially normal to the front surface 202. Further, the electronic device 102 is illustrated as having a longitudinal axis 206 (e.g., x-axis), a lateral axis 208 (e.g., y-axis), and a normal axis (e.g., z-axis). In aspects, the first camera 204 is aligned with (e.g., centered on) the lateral axis 208 and offset from the longitudinal axis 206, such that the first camera 204 is centered at the "top" of the front surface 202 when the electronic device 102 is in a landscape orientation.

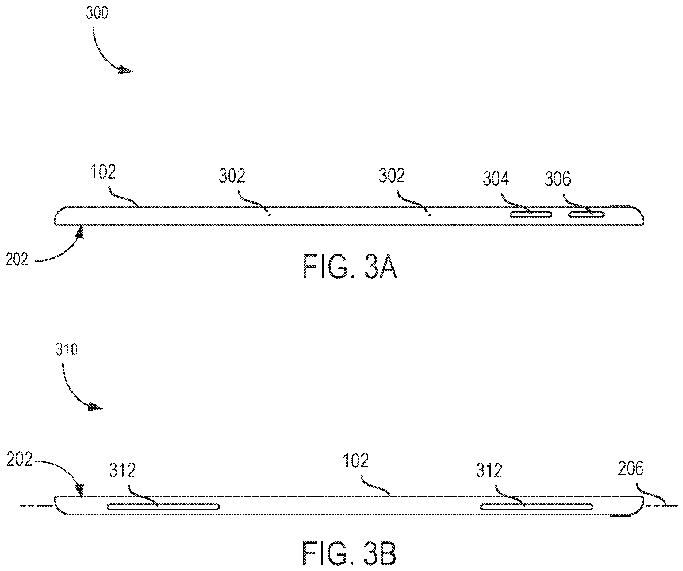

FIG. 3A illustrates a top plan view 300 of the electronic device 102 from FIG. 1. This top plan view 300 shows a side (e.g., "top" side) of the electronic device 102, which is lateral to the front surface 202 and which intersects the lateral axis 208 (and is parallel to the longitudinal axis 206). In aspects, the electronic device 102 may include one or more input mechanisms (e.g., a microphone port 302, a volume control button 304, a power button 306) disposed on the top side of the electronic device 102. Each microphone port 302 may be aligned with an audio sensor (e.g., microphone) disposed within the housing of the electronic device 102 and configured to detect voice input by the user.

FIG. 3B illustrates a bottom plan view 310 of the electronic device 102 from FIG. 1. This bottom plan view 310 shows another side (e.g., "bottom" side) of the electronic device 102 that is lateral to the front surface 202 and which is opposite the top side shown FIG. 3A. In some aspects, when the electronic device 102 is positioned in a landscape orientation and coupled to the base or leaning against an object, the bottom side rests on a surface. To reduce and/or prevent the electronic device 102 from slipping on the surface, the electronic device 102 includes one or more abrasion feet 312. The abrasion feet 312 protrude from the exterior surface of the electronic device 102. Further, the abrasion feet 312 include high-friction material to reduce slidable movement along the surface. In aspects, the abrasion feet 312 are arranged in a row that is parallel to the longitudinal axis 206 of the electronic device 102.

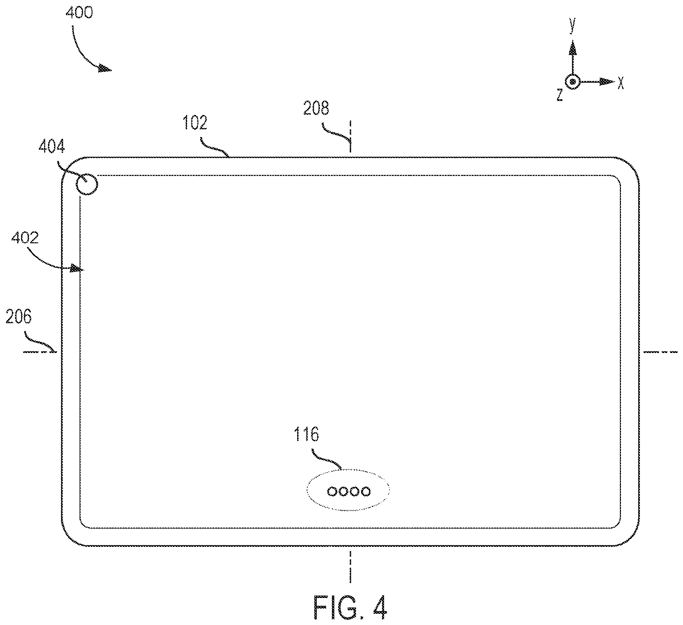

FIG. 4 illustrates a rear elevational view 400 of the electronic device 102 from FIG. 1. The illustrated example shows a rear surface 402 of the electronic device 102, which is opposite the front surface 202 defined by the touch-display device 110. The rear surface 402 includes an opening for a second camera 404 (e.g., a rear camera). The second camera 404 is disposed within the housing of the electronic device 102 and faces a direction parallel to the normal axis (e.g., z-axis). Also, the electrical contacts 116 are exposed via the rear surface 402. In some aspects, the electrical contacts 116 include a row of electrical connector mechanisms (e.g., pogo pads). The electrical contacts 116 may be arranged in any suitable pattern, including one or more rows substantially parallel to the longitudinal axis 206 and one or more columns substantially parallel to the lateral axis 208. The electrical contacts 116 are arranged in a suitable way so as to correspond to the corresponding receptacle contacts (e.g., electrical contacts 120) on the base. In some implementations, the electrical contacts 116 are positioned at a location on the rear surface 402 that is centered with respect to the lateral axis 208 and offset from the longitudinal axis 206 by an offset distance (e.g., 4 centimeters (cm), 5 cm, 6.25 cm, 7.3 cm, 8 cm). In aspects, the electrical contacts 116 may be offset from the bottom side of the electronic device 102 by a predefined distance (e.g., 2.5 cm, 3 cm, 3.75 cm, 5 cm).

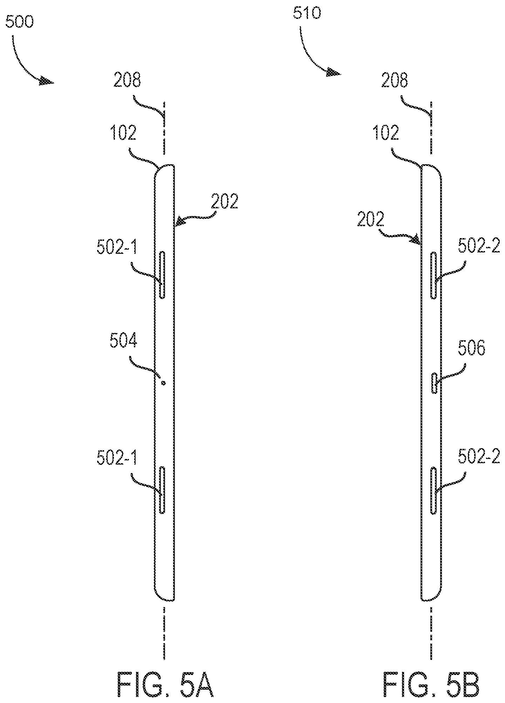

FIG. 5A illustrates a left elevational view 500 of the electronic device 102 from FIG. 1. This illustrated example shows a side (e.g., "left" side relative to the front view shown in FIG. 2) of the electronic device 102, which is lateral to the front surface 202 and intersects the longitudinal axis 206. The electronic device 102 includes one or more openings 502-1 for audio output by speakers. The electronic device 102 may also include a port 504 for an audio sensor (e.g., microphone) on the left side of the device. In this way, the electronic device 102 may include an audio sensor on both the top and left (and/or right) sides.

FIG. 5B illustrates a right elevational view 510 of the electronic device 102 from FIG. 1. This illustrated example shows another side (e.g., "right" side relative to the front view shown in FIG. 2) of the electronic device 102, which is lateral to the front surface 202 and opposite the left side shown in FIG 5A. The electronic device 102 may include, on the right side, one or more openings 502-2 for audio output by speakers. The electronic device 102 may also include an input/output port (e.g., Universal Serial Bus type-c (USB-C) port 506) or any other suitable I/O port for cable attachment for power transfer and electronic communication.

Because the electronic device 102 is a landscape-first orientation device, the top side and the bottom side are longer than the shorter left and right sides. As mentioned, the front camera is centered on the electronic device 102 with respect to the landscape orientation and disposed near the top side. The top side also includes microphone ports 302 for audio sensors that detect a user's voice and/or other sounds. The microphone ports 302 are disposed on the top side to reduce the likelihood of obstruction by some object when the electronic device 102 is docked or otherwise resting on a surface and leaning against another surface in the landscape orientation. Also, as mentioned, the electronic device 102 has openings 502-1 and 502-2 on the left and right sides, respectively, which are aligned with speakers for outputting audio toward both the left and right sides of the electronic device 102. Further, as mentioned, the abrasion feet 312 are disposed on the bottom side of the electronic device 102, and function to reduce or prevent slidable movement of the bottom side on a surface, such as e.g., when the electronic device 102 is resting on a surface and leaning against another surface. The specific arrangement of features of the electronic device 102, as described herein, provide a landscape-first orientation feature arrangement.

Unless context dictates otherwise, use herein of the word "or" may be considered use of an "inclusive or," or a term that permits inclusion or application of one or more items that are linked by the word "or" (e.g., a phrase "A or B" may be interpreted as permitting just "A," as permitting just "B," or as permitting both "A" and "B"). Also, as used herein, a phrase referring to "at least one of" a list of items refers to any combination of those items, including single members. For instance, "at least one of a, b, or c" can cover a, b, c, a-b, a-c, b-c, and a-b-c, as well as any combination with multiples of the same element (e.g., a-a, a-a-a, a-a-b, a-a-c, a-b-b, a-c-c, b-b, b-b-b, b-b-c, c-c, and c-c-c, or any other ordering of a, b, and c). Further, items represented in the accompanying figures and terms discussed herein may be indicative of one or more items or terms, and thus reference may be made interchangeably to single or plural forms of the items and terms in this written description.

Although implementations for a dockable and undockable multiple-purpose electronic tablet device have been described in language specific to certain features and/or methods, the subject of the appended claims is not necessarily limited to the specific features or methods described. Further, various different aspects are described, and it is to be appreciated that each described aspect can be implemented independently or in connection with one or more other described aspects.

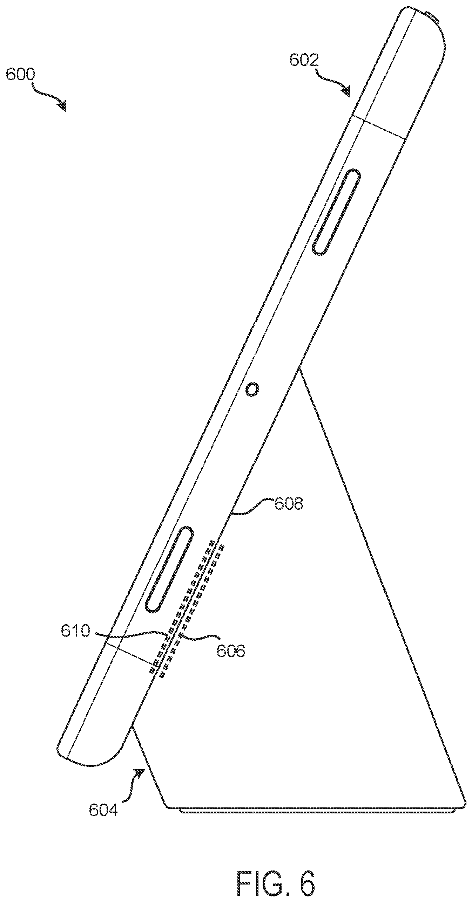

FIG. 6 illustrates a side view of a system 600 that includes an embodiment of an electronic device attached with a dock. As can be seen from the side view, the electronic device 602 is docked with dock 604. Region 606 indicates where a rear surface 608 of the electronic device 602 contacts the dock 604.

Within region 610, a first plurality of magnets is present within the electronic device 602. In corresponding locations within region 606, a second plurality of magnets is present within the dock 604. The magnets are arranged such that, when brought into proximity, the magnets of the electronic device 602 attract to the magnets of the dock 604 to help correctly position and align the dock 604 against the electronic device 602 and hold the electronic device 602 in a correct position on the dock 604. In other embodiments, regions 606 and 610 may extend further upward on the dock 604 and/or extend the length of the dock 604 which contacts the electronic device 602. For example, regions 606 and 610 may be any size and located at any location on the electronic device 602 and/or the dock 604.

An arrangement of magnets at the interface of the electronic device and the dock has been optimized according to various embodiments of the present invention. For example, a user "feel" of docking and undocking the electronic device from the dock was found to vary significantly based on the placement of magnets arranged on the electronic device and the dock. Accordingly, the arrangement of magnets described throughout the present disclosure has been optimized to reduce a number of "false homes" (e.g., misalignment incidents) when a user docks the electronic device to the dock and tipping incidents when the user interacts with the electronic device docked on the docked.

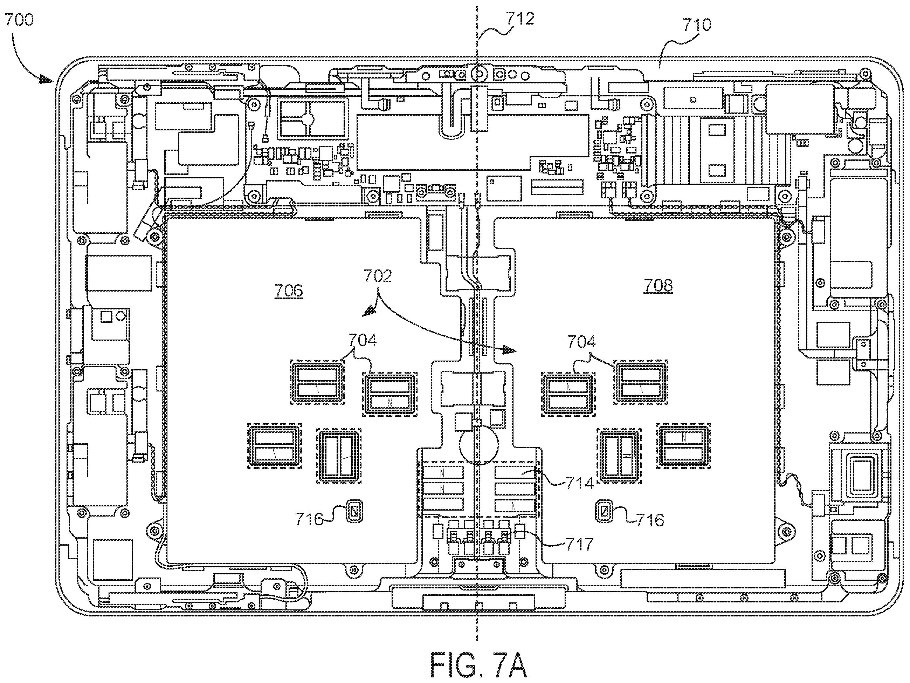

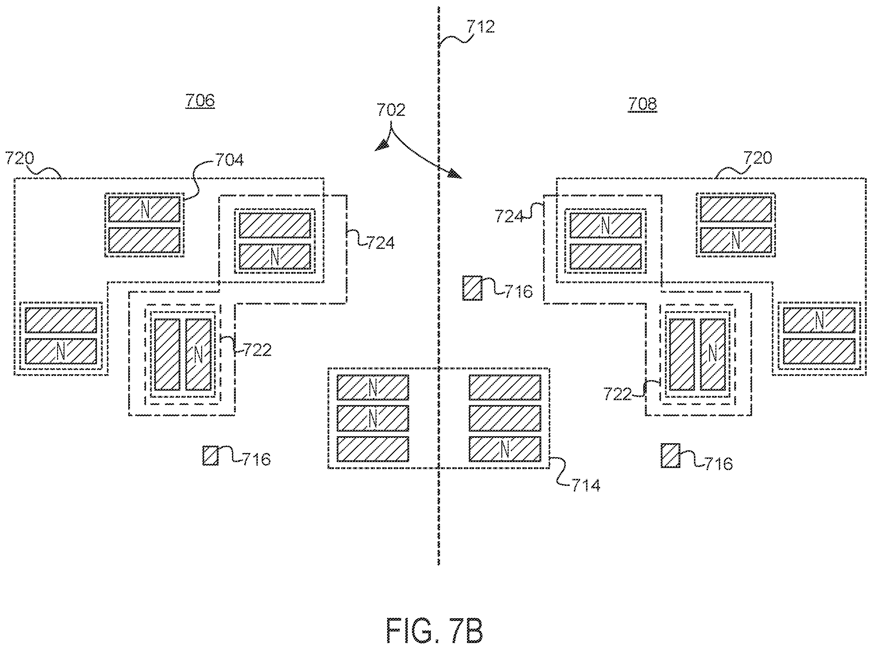

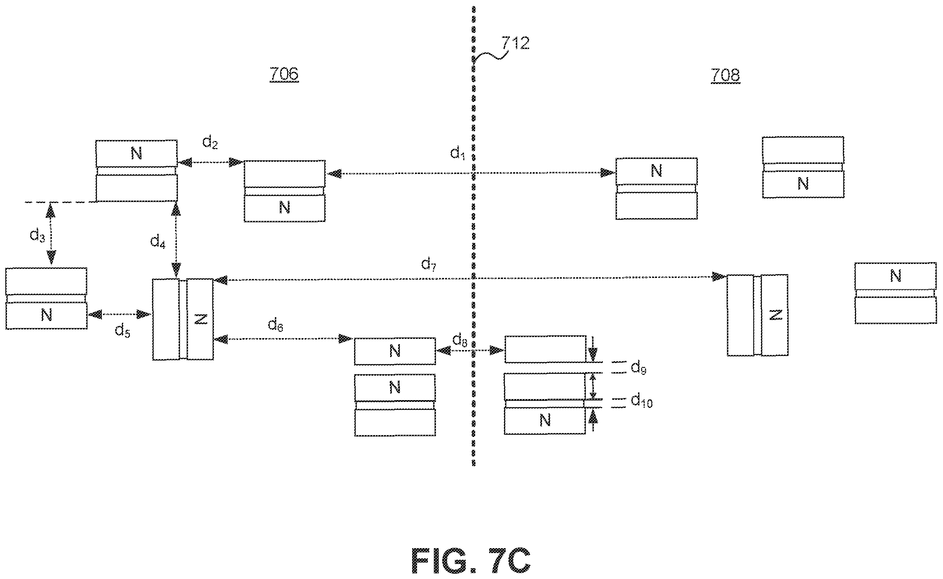

Referring now to FIG. 7, a cross-sectional view of an electronic device 700 is shown. Electronic device 700 may be a tablet computer that is configured to dock with a dock using magnets and can be removably docked from the dock using the magnets. In particular, the electronic device 700 may be a smart home assistance device as previously detailed. The electronic device 700 includes a plurality of magnets 702 arranged to magnetically couple with another plurality of magnets of a dock. The plurality of magnets 702 are formed in an arrangement having at least four groups 704 on the first lateral side 706 and the second lateral side 108of the electronic device 700 (more particularly, an enclosure 710 of the electronic device 700). In various embodiments, the at least four groups 704 on the first lateral side 706 are in a mirrored configuration to the at least four groups 704 on the second lateral side 708. For example, the size and location of the at least four groups 704 of magnets are reflected across a longitudinal axis 712 of the electronic device 700.

In various embodiments, the plurality of magnets 702 are grouped (e.g., arranged) in pairs, as shown. For example, the pairs of magnets in the plurality of magnets 702 have opposed north and south orientations in-plane with respect to a surface of the electronic device 700. For example, magnets within each group of magnets are arranged such that opposite poles are oriented toward one another. Such an arrangement of opposing poles may concentrate the magnetic field for facilitating alignment of the electronic device 700 when docked to a dock and preventing misalignment of the electronic device 700 and the dock. In other embodiments, the plurality of magnets 702 are arranged in trios. The pairs of the plurality of magnets 702 may have a polarity such that they magnetically attract corresponding magnets in a dock. For example, a magnet in the plurality of magnets 702 is oriented within the electronic device 700 such that a corresponding magnet in the dock has the opposite polarity of the magnet in the plurality of magnets 702. Such an arrangement allows the first plurality of magnets (e.g., magnets 702) in the electronic device 700 to be attracted to a second plurality of magnets of the dock. The arrangement and number of the plurality of magnets 702 may vary. For example, the electronic device 700 shows 16 magnets in the plurality of magnets 702. Accordingly, a second plurality of magnets may include 16 magnets corresponding to the plurality of magnets 702. In other embodiments, any number of magnets may be grouped together. For example, one magnet, three magnets, two pairs of magnets, etc., may form a group. In yet another example, the number of magnets within a group may vary (e.g., one magnet within one group and two magnets in a second group, etc.).

The electronic device 700 may further include an additional group of magnets 714 disposed generally along a longitudinal axis of the electronic device 700. As shown, the additional group of magnets 714 is arranged in two columns, with one column on each side of the longitudinal axis. Each column includes three magnets, although any number of magnets may be included in the additional group of magnets 714 or each column of the additional group of magnets. The additional group of magnets 714 may be configured to magnetically couple with a different plurality of magnets of an alternative dock. For example, a smaller dock may be desired in various applications as a back-up charger or alternative docking station within a user's home. Alternative, smaller docks may be interchangeable with a main, larger dock, such as dock 604 shown in FIG. 6, or as described throughout the present disclosure. In various embodiments, the electronic device 700 does not include the additional group of magnets 714.

The electronic device 700 may further include one or more stimuli magnets 716 located on the electronic device 700 for detecting tilt of the electronic device 700. For example, the stimuli magnets 716 may be part of a tilt sensor or otherwise configured to transmit a signal indicative of a tilt when the electronic device 700 is tilted, in a manner which would be understood by one having ordinary skill in the art. In some embodiments, the stimuli magnets 716 are used to pair with a Hall effect sensor on the electronic device 700 for detecting whether the electronic device 700 is close to the dock to enable charging.

In at least some embodiments, at one stimuli magnet 716 is located on each side of the longitudinal axis 712 of the electronic device 700 to detect tilt and to ensure charging only occurs when the electronic device 700 is placed on the dock within a predetermined tilt. For example, the electronic device 700 may include a series of contact pads 717 (such as electrical contacts 116 and corresponding receptacle contacts 120 described above for providing power and signal to the electronic device 700 from the dock and vice versa) and the charging may only occur if the tilt is within the predetermined range and the series of contact pads 717 are engaged. For example, if only of the at one stimuli magnet 716 on each side of the longitudinal axis 712 of the electronic device 700 is within the predetermined tilt range but the four pins are substantially aligned, charging will not occur. Providing a predetermined tilt for each of the stimuli magnets 716 reduces shorting of the corresponding receptacle contacts (e.g., spring-loaded pins) which may occur if the contact pads 717 are misaligned (e.g., aligning a spring-loaded pin configured to provide power with a spring-loaded pin configured to provide data may result in shorting of the materials within one of the spring-loaded pins).

In some embodiments, any of the magnets described with respect to the electronic device 700 may include a shunt (not shown) coupled to the magnets for directing a magnetic field associated with the one or more magnets. For example, the magnetic field of the magnets must travel at least through the enclosure 710 of the electronic device 700 to magnetically couple (e.g., attract to) corresponding magnets on a dock. Shunts may be used to help further define the direction of the magnetic field to optimize the magnetic force and the user experience of docking/undocking of the electronic device 700 from the dock. For example, a user may have more confidence that the electronic device 700 is docked to a dock when the force of the magnets is exaggerated by additional shunts implemented with the magnets.

In various embodiments, a gap is optimized between the magnets 702 and the corresponding magnets in the dock. The gap is in a range of 1.65 mm to 2.5 mm when the electronic device is docked to the dock. The gap is optimized to further direct and consolidate the magnetic forces between corresponding pluralities of magnets within the electronic device 700 and the dock.

Referring now to FIG. 7B, the arrangement of the plurality of magnets 702, the additional group of magnets 714, and the stimuli magnets 716, as shown in FIG. 7A, is illustrated with the other components of the electronic device 700 removed for simplicity. The arrangement of magnets within the electronic device 700 is optimized to improve the user's experience when docking and undocking the electronic device 700 from a dock. The arrangement of magnets, according to various embodiments described herein, optimally includes an alternating arrangement of polarities along the outermost three groups 720 of magnets 702 on the first lateral side 706 and the second lateral side 108of the longitudinal axis 712. These at least four groups 704 are arranged horizontally, to be described in further detail below. Additionally, the arrangement of magnets includes that the two vertically oriented groups (e.g., fourth groups 722) of magnets 702 include matching north and south polarities across the two groups, to be described in further detail below.

As described with respect to FIG. 7A, at least four groups 704 of magnets 702 on a first lateral side 706 are in a mirrored configuration to at least four groups 704 of magnets 702 on a second lateral side 708, as shown. The mirrored configuration advantageously prevents or significantly reduces the number of occurrences of "false homes" (e.g., when a user brings the electronic device close to a dock, a false home occurs when the electronic device is attracted to the wrong magnets on the dock and the electronic device is temporarily misaligned with the dock before recentering).

According to embodiments described herein, at least three groups (e.g., the outermost three groups 720) of the at least four groups 704 on the first lateral side 706 and the second lateral side 708 are oriented horizontally and the fourth group 722 is oriented vertically. Having a majority of the groups of magnets on each side of the electronic device oriented in the horizontal direction provides stability to the system, especially during button presses. For example, a button press may include a user is interacting with buttons along the top edge of the electronic device 700 (such as a volume control button 304 and/or a power button 306 as described with respect to FIG. 3A). Horizontally oriented groups increase the magnetic strength in the y-direction such that any tipping resulting from interacting with a top edge or corner of the electronic device is minimized. The outermost three groups 720 on the first lateral side 706 and the second lateral side 108include alternating north and south polarity across (e.g., from left to right) the three outermost three groups 720, as indicated the "N" for North polarity. The alternating polarity further prevents false home occurrences and misalignment of the electronic device and the dock by reducing the number of available magnets in the correct orientation (e.g., such that the magnets would be attracted to one another) being in close proximity to one another. The resulting docking experience is a fluid movement from bringing the electronic device in proximity to the dock and the magnetic coupling of the electronic device and the dock. The fluid docking movement may be substantially in the horizontal direction as the majority of the magnets placed in the horizontal direction guide the electronic device across the surface of the dock into the electronic device's final docking position.

The vertically oriented groups (e.g., fourth groups 722) of magnets facilitate alignment of the electrical contact pads of the electronic device 700 and the pins of the dock (such as electrical contacts 116 and pins described above for providing power and signal to the electronic device 700 from the dock and vice versa). The vertically oriented groups (e.g., fourth groups 722) of magnets further guide the electronic device 700 vertically into position on the surface of the dock such as when the electronic device 700 is brought slightly above or below the arrangement of magnets, specifically, the horizontally aligned outermost three groups 720.

In various embodiments, the two innermost groups 724 of magnets include matching north and south polarities across the two innermost groups 724. Said another way, the two innermost groups 724 have the same polarity facing toward the longitudinal axis 712. This "L-shaped" or "arc-shaped" polarity provides support to the electronic device 700 when it is docked to a dock and a user is interacting with buttons along the top edge of the electronic device 700 (such as a volume control button 304 and/or a power button 306 as described with respect to FIG. 3A). For example, when a user presses the volume or power buttons, the user is applying a force downward from the top edge of the electronic device. The magnets must be arranged to counteract that downward force such that the electronic device does not unexpectedly release from the dock. The arc-shape polarity created by the inwardly facing matching polarities acts to counter any rocking motion that would be experienced by a docked electronic device when a user interacts with buttons on a top edge of the electronic device.

Referring now to FIG. 7C, an arrangement of magnets is shown with optimized distances, in accordance with at least some embodiments of the present disclosure. All distances shown have a tolerance of ± 0.1 mm, inclusive. For example, a distance between a group of magnets being 1.0 mm is understood to include 0.9 mm and 1.1 mm and any integer therebetween. Similar numbering as in FIGS. 7A-7B have similar definitions as those described above with respect to other FIGS.

A plurality of magnets 702 is arranged according to at least some embodiments of the present disclosure. The plurality of magnets 702 are mirrored on the first lateral side 706 and the second lateral side 108of the longitudinal axis 712 and distances shown on the first lateral side 706 of the plurality of magnets 702 are assumed to be the same between corresponding magnets on the second lateral side 708. Starting from the first lateral side 706, d₁ is 42.72 mm, d₂ is 9.64 mm, d₃ is 9.5 mm, d₄ is 11.14 mm, d₅ is 9.57 mm, d₆ is 20.93 mm, d₇ is 75.86mm, d₈ is 10.00 mm, d₉ is 1.4 mm, and d₁₀ is 1.0 mm.

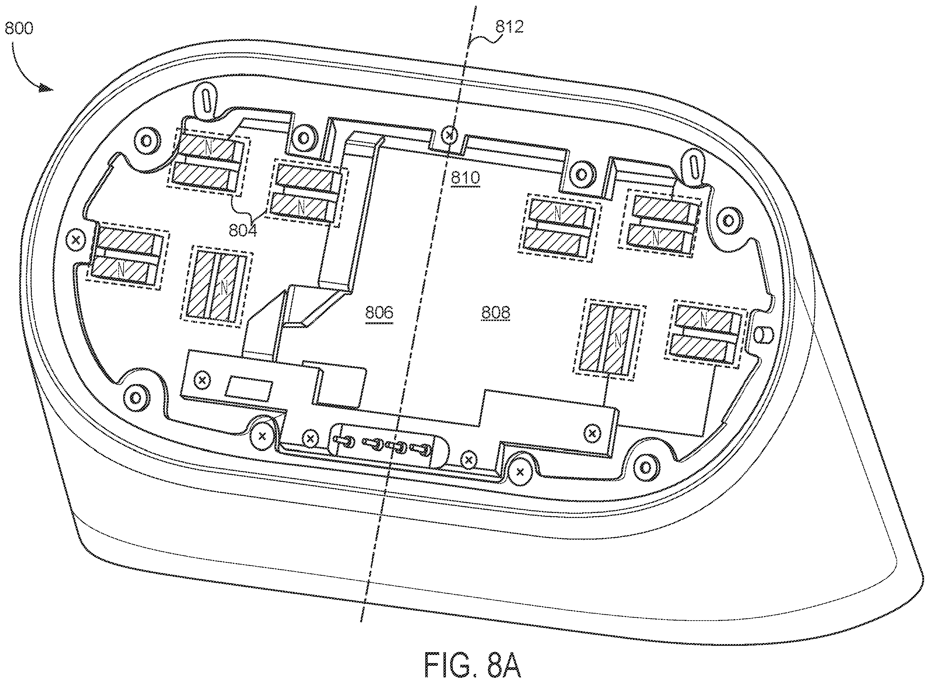

Referring now to FIG. 8A, a top, cross-sectional view of a dock 800 is shown. Dock 800 may be a dock that is configured to magnetically couple with an electronic device (such as electronic device 700 or any tablet computer described herein). In particular, the dock 800 may be used with an electronic device as part of a smart home assistance device as previously detailed. The dock 800 includes a plurality of magnets 802 arranged to magnetically couple with another plurality of magnets of the electronic device. The plurality of magnets 802 are formed in an arrangement having at least four groups 804 on the first lateral side 806 and the second lateral side 808 of the dock 800 (more particularly, a face plate 810 of the dock 800). In various embodiments, the at least four groups 804 on the first lateral side 806 are in a mirrored configuration to the at least four groups 804 on the second lateral side 808. For example, the size and location of the at least four groups 804 of magnets are reflected across a longitudinal axis 812 of the dock 800, similarly to the at least four groups 704 of magnets described with respect to the electronic device 700.

In various embodiments, the plurality of magnets 702 are grouped (e.g., arranged) in pairs, as shown. For example, the pairs of magnets in the plurality of magnets 802 have opposed north and south orientations in-plane with respect to a surface of the dock 800. Such an arrangement of opposing poles may concentrate the magnetic field for facilitating alignment of an electronic device when docked to the dock 800. In other embodiments, the plurality of magnets 802 are arranged in trios. The pairs of the plurality of magnets 802 may have a polarity such that they magnetically attract corresponding magnets in an electronic device, as previously detailed. For example, a magnet in the plurality of magnets 802 is oriented within the dock 800 such that a corresponding magnet in the electronic device has the opposite polarity of the magnet in the plurality of magnets 802. Such an arrangement allows the first plurality of magnets (e.g., magnets 802) in the dock 800 to be attracted to a second plurality of magnets of the electronic device. The arrangement and number of the plurality of magnets 802 may vary. For example, the dock 800 shows 16 magnets in the plurality of magnets 802. Accordingly, a second plurality of magnets may include 16 magnets corresponding to the plurality of magnets 802. In other embodiments, any number of magnets may be grouped together. For example, one magnet, three magnets, two pairs of magnets, etc., may form a group. In yet another example, the number of magnets within a group may vary (e.g., one magnet within one group and two magnets in a second group, etc.).

In some embodiments, any of the magnets described with respect to the dock 800 may include a shunt (not shown) coupled to the magnets for directing a magnetic field associated with the one or more magnets. For example, the magnetic field of the magnets must travel at least through the face plate 810 of the dock 800 to magnetically couple (e.g., attract to) corresponding magnets on an electronic device. Shunts may be used to help further define the direction of the magnetic field to optimize the magnetic force and docking/undocking of the electronic device from the dock 800, as described in detail above with respect to shunts of the electronic device 700.

In various embodiments, a gap is optimized between the magnets 802 and corresponding magnets in the electronic device. The gap is in a range of 1.65 mm to 2.5mm when the electronic device is docked to the dock. The gap is optimized to further direct and consolidate the magnetic forces between corresponding pluralities of magnets within the electronic device and the dock 800.

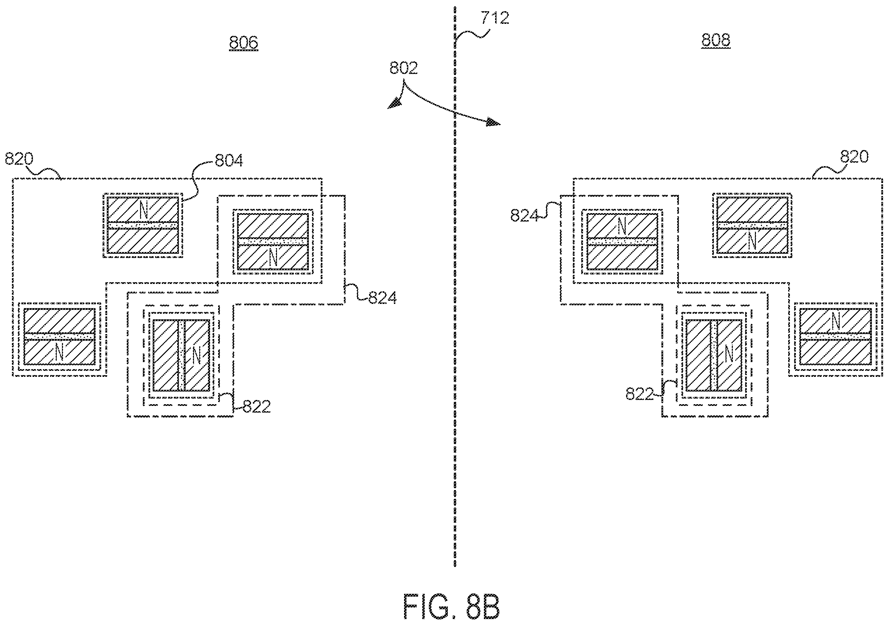

Referring now to FIG. 8B, the arrangement of the plurality of magnets 802 as shown in FIG. 8A is illustrated with the other components of the dock 800 removed for simplicity. The arrangement of magnets within the dock 800 is optimized to improve the user's experience when docking and undocking an electronic device from the dock 800. The arrangement of magnets, according to various embodiments described herein, optimally includes an alternating arrangement of polarities along the outermost three groups 820 of magnets 802 on the first lateral side 806 and the second lateral side 808 of the longitudinal axis 812 where the at least four groups 804 are arranged horizontally, to be described in further detail below. Additionally, the arrangement of magnets includes that the two vertically oriented groups (e.g., fourth groups 822) of magnets 802 include matching north and south polarities across the two groups, to be described in further detail below. As would be understood by one having ordinary skill in the art upon reading the present disclosure, the arrangement of the plurality of magnets 802 is substantially similar to the arrangement of the plurality of magnets 702 described with respect to FIGS. 7A-7B. Accordingly, similar arrangements may be provided for similar reasoning as both the plurality of magnets 802 on the dock and a plurality of magnets on an electronic device (such as a plurality of magnets 702 on an electronic device 700) are optimized to provide improved magnetic coupling and docking between an electronic device and the dock.

As described with respect to FIG. 8A, at least four groups 804 of magnets 802 on a first lateral side 806 are in a mirrored configuration to at least four groups 804 of magnets 802 on a second lateral side 808, as shown. The mirrored configuration advantageously prevents or significantly reduces the number of occurrences of "false homes" (e.g., when a user brings the electronic device close to a dock, a false home occurs when the electronic device is attracted to the wrong magnets on the dock and the electronic device is temporarily misaligned with the dock before recentering).

According to embodiments described herein, at least three groups (e.g., the outermost three groups 820) of the at least on the first lateral side 806 and the second lateral side 808 are oriented horizontally and the fourth group 822 is oriented vertically. Having a majority of groups of magnets on each side of the electronic device oriented in the horizontal direction provides stability to the system, especially during button presses as a user is interacting with buttons along the top edge of the dock 800 (such as a volume control button 304 and/or a power button 306 as described with respect to FIG. 3A). Horizontally oriented groups increase the magnetic strength in the y-direction such that any tipping resulting from interacting with a top edge or corner of the electronic device is minimized. The outermost three groups 820 on the first lateral side 806 and the second lateral side 808 include alternating north and south polarity across (e.g., from left to right) the outermost three groups 820, as indicated the "N" for North polarity. The alternating polarity further prevents false home occurrences and misalignment of the electronic device and the dock by reducing the number of available magnets in the correct orientation (e.g., such that the magnets would be attracted to one another) being in close proximity to one another.

In various embodiments, the two innermost groups 824 of magnets include matching north and south polarities across the two innermost groups 824. Said another way, the two innermost groups 824 have the same polarity facing toward the longitudinal axis 812. This "L-shaped" or "arc-shaped" polarity provides support to the dock 800 when it is docked to a dock and a user is interacting with buttons along the top edge of the dock 800 (such as a volume control button 304 and/or a power button 306 as described with respect to FIG. 3A), as described with respect to FIG. 7B.

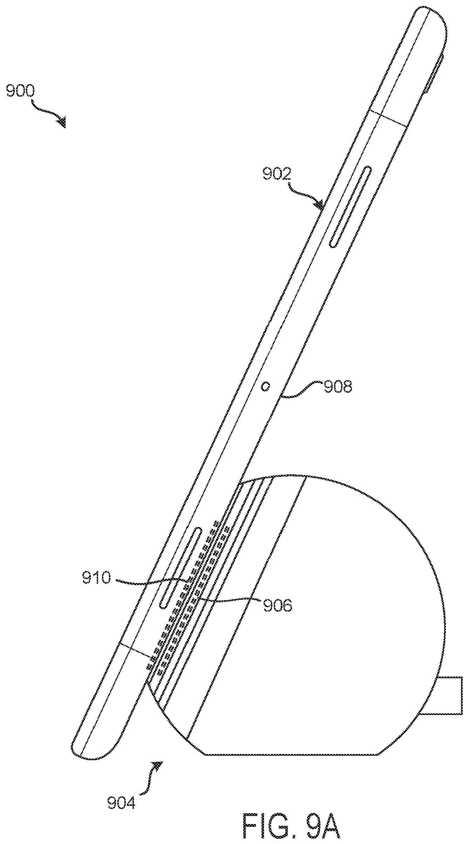

FIG. 9A illustrates a side view of a system 900 that includes an embodiment of an electronic device attached with an alternative dock design than the dock design illustrated in FIG. 6 and other figures. The dock described with respect to FIGS. 9A-9B operates substantially the same as other docks described herein, unless otherwise noted, and only differs in size and configuration as detailed herein. A relatively smaller dock design may be suitable for additional docking stations in a user's home, in addition to a main, relatively larger design dock as shown throughout the present invention. In other embodiments, a user may desire a smaller design for any other reason.

As can be seen from the side view, the electronic device 902 is docked with dock 904. Region 906 indicates where a rear surface 908 of the electronic device 902 contacts the dock 904.Within region 910, a first plurality of magnets is present within the electronic device 602. In corresponding locations within region 906, a second plurality of magnets is present within the dock 904. The magnets are arranged such that, when brought into proximity, the magnets of the electronic device 902 attract to the magnets of the dock 904 to help correctly position and align the dock 904 against the electronic device 902 and hold the electronic device 902 in a correct position on the dock 904. In other embodiments, regions 906 and 910 may extend further upward on the dock 904 and/or extend the length of the dock 904 which contacts the electronic device 902. For example, regions 906 and 910 may be any size and located at any location on the electronic device 902 and/or the dock 904.

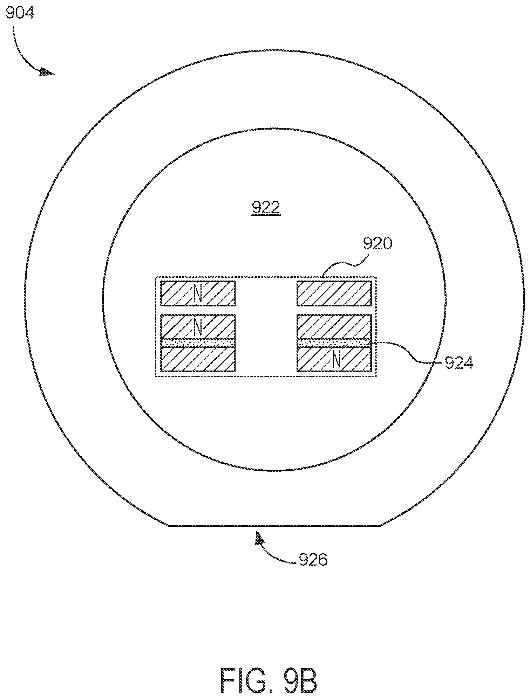

Referring now to FIG. 9B, a top cross-sectional view of the dock 904 having an arrangement of magnets 920 is illustrated. The arrangement of magnets 920 may be suitable for magnetically coupling with a group of magnets on an electronic device (such as the additional group of magnets 714 of electronic device 700). In various embodiments, the arrangement of magnets 920 is arranged in two groups of three, as shown. The arrangement of magnets 920 may have a polarity such that they magnetically attract corresponding magnets in an electronic device, as previously detailed. For example, a magnet in the arrangement of magnets 920 is oriented within the dock 904 such that a corresponding magnet in the electronic device has the opposite polarity of the magnet in the arrangement of magnets 920. Such an arrangement allows the arrangement of magnets 920 in the dock 904 to be attracted to a second plurality of magnets of the electronic device. The arrangement and number of the arrangement of magnets 920 may vary. For example, the dock 904 shows 6 magnets in the arrangement of magnets 920. In other embodiments, any number of magnets may be grouped together. For example, one magnet, three magnets, two pairs of magnets, etc., may form a group in the arrangement. In yet another example, the number of magnets within a group may vary (e.g., one magnet within one group and two magnets in a second group, etc.).

In some embodiments, any of the magnets described with respect to the dock 904 may include a shunt 924 coupled to the magnets for directing a magnetic field associated with the one or more magnets. For example, the magnetic field of the magnets must travel at least through the face plate 922 of the dock 904 to magnetically couple (e.g., attract to) corresponding magnets on an electronic device. Shunts may be used to help further define the direction of the magnetic field to optimize the magnetic force and docking/undocking of the electronic device from the dock 904. As shown, a shunt 924 is coupled to each of the bottommost pairs of magnets in the arrangement of magnets. Each shunt may be 1.0 mm thick. In various embodiments, these magnets are stronger and/or thicker relative to the topmost magnets in the arrangement of magnets. For example, the relatively thicker magnets may be 4.0 mm thick in some embodiments. In other embodiments, the relatively thicker magnets may be 2.5 mm thick. In comparison, other magnets, such as magnets located on a corresponding electronic device, may be 0.6 mm thick. For example, because the dock 904 is relatively small and has a lower pivot point and center of gravity (making the dock more susceptible to tipping when the electronic device is interacted with), stronger magnets are used closer to a bottom surface 926 of the dock 904 to increase stability of the tablet computer system.

In various embodiments, a gap is optimized between the magnets 920 and corresponding magnets in the electronic device The gap is in a range of 1.65 mm to 2.5 mm when the electronic device is docked to the dock. As described above, the air gap is optimized to further direct and consolidate the magnetic forces between corresponding pluralities of magnets within the electronic device and the dock 904.

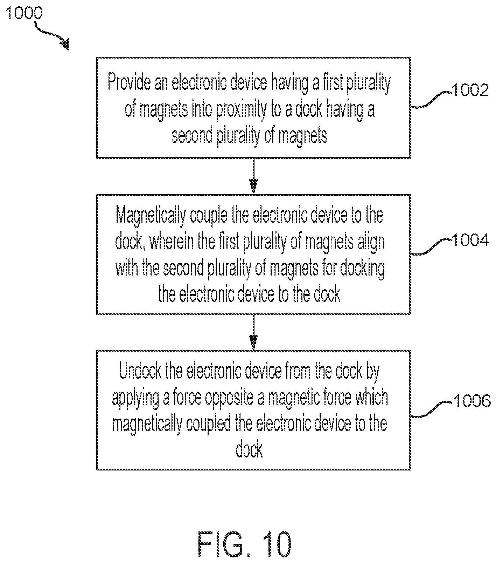

FIG. 10 is a flowchart of a method 1000 for docking and undocking an electronic device from a dock. Step 1002 includes providing an electronic device having a first plurality of magnets into proximity to a dock having a second plurality of magnets. The electronic device and dock may include any of the embodiments described herein, including any of the arrangements of magnets described herein. For example, the electronic device may include at least four groups of magnets on each lateral side of the enclosure, where the at least four groups of magnets on a first lateral side of the enclosure are in a mirrored configuration to the at least four groups of magnets on a second lateral side of the face of the enclosure. In addition, at least three of the groups of magnets on each lateral side of the enclosure may be oriented horizontally and a fourth group of magnets on each lateral side of the face of the enclosure may be oriented vertically. Further, the three horizontally oriented groups of magnets on each side of the enclosure may include alternating north and south polarity across the three groups of magnets, from left to right across the enclosure, and the two innermost groups of magnets include matching north and south polarities across the two groups, from left to right across the enclosure. The dock includes a corresponding arrangement of magnets having the second plurality of magnets such that the electronic device magnetically couples to the dock, as would be appreciated by one having ordinary skill in the art upon reading the present disclosure. Step 1004 includes magnetically coupling the electronic device to the dock where the first plurality of magnets aligns with the second plurality of magnets for docking the electronic device to the dock. Step 1006 may include undocking the electronic device from the dock by applying a force opposite a magnetic force which magnetically coupled the electronic device to the dock. For example, a user may pull and/or pivot the electronic device away from the dock such that the force applied by the user interrupts the magnetic coupling which previously secured the electronic device to the dock. In some embodiments, a user pivots the electronic device down and away from the dock to undock the electronic device from the dock to reduce unwanted tipping of the dock once the electronic device uncouples from the dock. For example, in some instances, the magnets of the electronic device remain attracted to the magnets of the dock as the electronic device is pulled away from the dock and may bring the dock a short distance along with the electronic device. Certain pulling and pivoting mechanisms employed by a user may be used to counteract these effects.

It should be noted that the methods, systems, and devices discussed above are intended merely to be examples. It must be stressed that various embodiments may omit, substitute, or add various procedures or components as appropriate. For instance, it should be appreciated that, in alternative embodiments, the methods may be performed in an order different from that described, and that various steps may be added, omitted, or combined. Also, features described with respect to certain embodiments may be combined in various other embodiments. Different aspects and elements of the embodiments may be combined in a similar manner. Also, it should be emphasized that technology evolves and, thus, many of the elements are examples and should not be interpreted to limit the scope of the invention.

Specific details are given in the description to provide a thorough understanding of the embodiments. However, it will be understood by one of ordinary skill in the art that the embodiments may be practiced without these specific details. For example, well-known, processes, structures, and techniques have been shown without unnecessary detail in order to avoid obscuring the embodiments. This description provides example embodiments only, and is not intended to limit the scope, applicability, or configuration of the invention. Rather, the preceding description of the embodiments will provide those skilled in the art with an enabling description for implementing embodiments of the invention.

Also, it is noted that the embodiments may be described as a process which is depicted as a flow diagram or block diagram. Although each may describe the operations as a sequential process, many of the operations can be performed in parallel or concurrently. In addition, the order of the operations may be rearranged. A process may have additional steps not included in the figure.

For example, the above elements may merely be a component of a larger system, wherein other rules may take precedence over or otherwise modify the application of the invention. Also, a number of steps may be undertaken before, during, or after the above elements are considered. Accordingly, the above description should not be taken as limiting the scope of the invention.

## Claims

1. A tablet computer system, comprising:
a dock (104, 604, 800);
a tablet computer (102, 602, 700, 902) which can be removably docked from the dock (104, 604, 800), the tablet computer (102, 602, 700, 902) comprising:
an electronic display (110);
an enclosure (710) housing the electronic display (110); and
a first plurality of magnets (702), wherein the first plurality of magnets is arranged to magnetically couple with a second plurality of magnets (802) of the dock,
the first plurality of magnets (702) formed in an arrangement comprising:
at least four groups of magnets on each lateral side (706, 708) of the enclosure (710), wherein:
the at least four groups of magnets on a first lateral side (706) of the enclosure (710) are in a mirrored configuration to the at least four groups of magnets on a second lateral (708) side of the enclosure (710),
at least three of the groups of magnets (720) on each lateral side (706, 708) of the enclosure (710) are oriented horizontally and a fourth group of magnets (722) on each lateral side (706, 708) of the enclosure (710) is oriented vertically, the three groups of magnets (720) on each lateral side (706, 708) of the enclosure (710) comprising alternating north and south polarity across the three groups of magnets, and
the two innermost groups of magnets (724) comprising matching north and south polarities across the two innermost groups of magnets.

2. The tablet computer system of claim 1, wherein a gap between first plurality of magnets (702) and the second plurality of magnets (802) is in a range of 1.65 mm to 2.5 mm when the tablet computer (102, 602, 700, 902) is docked to the dock (104, 604, 800).

3. The tablet computer system of claim 1, further comprising a stimuli magnet on the enclosure (710) for detecting tilt of the tablet computer (102, 602, 700, 902).

4. The tablet computer system of claim 1, further comprising an additional group of magnets disposed along a longitudinal axis of the enclosure (710), the additional group of magnets being configured to magnetically couple with a third plurality of magnets of an alternative dock (904).

5. The tablet computer system of claim 1, wherein each group of magnets comprises two magnets.

6. The tablet computer system of claim 1, wherein magnets within each group of magnets are arranged in opposing north and south polarities.

7. The tablet computer system of claim 1, wherein magnets within each group of magnets are arranged such that opposite poles are oriented toward one another.

8. A tablet computer (102, 602, 700, 902), comprising:
an electronic display (110);
an enclosure (710) housing the electronic display (110); and
a first plurality of magnets (702), wherein the first plurality of magnets (702) is arranged to magnetically couple with a second plurality of magnets (802) of a dock (104, 604, 800),
the first plurality of magnets (702) formed in an arrangement comprising:
at least four groups of magnets on each lateral side (706, 708) of the enclosure (710), wherein:
the at least four groups of magnets on a first lateral side (706) of the enclosure (710) are in a mirrored configuration to the at least four groups of magnets on a second lateral (708) side of the enclosure (710),
at least three of the groups of magnets (720) on each lateral side (706, 708) of the enclosure (710) are oriented horizontally and a fourth group of magnets (722) on each lateral side (706, 708) of the enclosure (710) is oriented vertically, the three groups of magnets (720) on each lateral side (706, 708) of the enclosure (710) comprising alternating north and south polarity across the three groups of magnets, and
the two innermost groups of magnets (724) comprising matching north and south polarities across the two innermost groups of magnets.

9. The tablet computer (102, 602, 700, 902) of claim 8, wherein a gap between first plurality of magnets (702) and the second plurality of magnets (802) is in a range of 1.65 mm to 2.5 mm when the tablet computer is docked to the dock (104, 604, 800).

10. The tablet computer (102, 602, 700, 902) of claim 8, further comprising a stimuli magnet on the enclosure (710) for detecting tilt of the tablet computer (102, 602, 700, 902).

11. The tablet computer (102, 602, 700, 902) of claim 8, further comprising an additional group of magnets disposed along a longitudinal axis of the enclosure (710), the additional group of magnets being configured to magnetically couple with a third plurality of magnets of an alternative dock (904).

12. The tablet computer (102, 602, 700, 902) of claim 8, wherein each group of magnets comprises two magnets.

13. The tablet computer (102, 602, 700, 902) of claim 8, wherein magnets within each group of magnets are arranged in opposing north and south polarities.

14. A dock (104, 604, 800), comprising:
a dock housing;
a face plate (810, 922), the face plate (810, 922) removably coupled to a tablet computer (102, 602, 700, 902); and
a second plurality of magnets (802), wherein the second plurality of magnets (802) is arranged to magnetically couple with a first plurality of magnets (702) of the tablet computer (102, 602, 700, 902),
the second plurality of magnets (802) formed in an arrangement comprising:
at least four groups of magnets on each lateral side (806, 808) of the face plate (810, 922), wherein:
the at least four groups of magnets on a first lateral side (806) of the face plate (810, 922) are in a mirrored configuration to the at least four groups of magnets on a second lateral side (808) of the face plate(810, 922),
at least three of the groups of magnets (820) on each lateral side (806, 808) of the face plate(810, 922) are oriented horizontally and a fourth group of magnets (822) on each lateral side (806, 808) of the face plate (810, 922) is oriented vertically, the three groups of magnets (820) on each lateral side (806, 808) of the face plate (810, 922) comprising alternating north and south polarity across the three groups of magnets, and
the two innermost groups of magnets (824) comprising matching north and south polarities across the two innermost groups of magnets.

15. The dock of claim 14, wherein a gap between first plurality of magnets and the second plurality of magnets is in a range of 1.65 mm to 2.5 mm when the tablet computer is docked to the dock or magnets within each group of magnets are arranged in opposing north and south polarities.

## Patentansprüche

1. Tablet-Computersystem, umfassend:
eine Dockingstation (104, 604, 800);
einen Tablet-Computer (102, 602, 700, 902), der lösbar von der Dockingstation (104, 604, 800) angedockt werden kann, wobei der Tablet-Computer (102, 602, 700, 902) umfasst:
eine elektronische Anzeige (110)
ein Gehäuse (710), das die elektronische Anzeige (110) beherbergt; und
eine erste Vielzahl von Magneten (702), wobei die erste Vielzahl von Magneten so angeordnet ist, dass sie magnetisch mit einer zweiten Vielzahl von Magneten (802) der Dockingstation koppelt, wobei die erste Vielzahl von Magneten (702) in einer Anordnung ausgebildet ist, die umfasst:
wenigstens vier Gruppen von Magneten auf jeder lateralen Seite (706, 708) des Gehäuses (710), wobei:
die wenigstens vier Gruppen von Magneten auf einer ersten lateralen Seite (706) des Gehäuses (710) in einer gespiegelten Konfiguration zu den wenigstens vier Gruppen von Magneten auf einer zweiten lateralen Seite (708) des Gehäuses (710) sind,
wenigstens drei der Gruppen von Magneten (720) auf jeder lateralen Seite (706, 708) des Gehäuses (710) horizontal ausgerichtet sind und eine vierte Gruppe von Magneten (722) auf jeder lateralen Seite (706, 708) des Gehäuses (710) vertikal ausgerichtet ist, wobei die drei Gruppen von Magneten (720) auf jeder lateralen Seite (706, 708) des Gehäuses (710) eine alternierende Nord- und Südpolarität über die drei Gruppen von Magneten umfassen, und
die zwei innersten Gruppen von Magneten (724) übereinstimmende Nord- und Südpolaritäten über die zwei innersten Gruppen von Magneten umfassen.

2. Tablet-Computersystem nach Anspruch 1, wobei ein Spalt zwischen der ersten Vielzahl von Magneten (702) und der zweiten Vielzahl von Magneten (802) in einem Bereich von 1,65 mm bis 2,5 mm liegt, wenn der Tablet-Computer (102, 602, 700, 902) an der Dockingstation (104, 604, 800) angedockt ist.

3. Tablet-Computersystem nach Anspruch 1, ferner umfassend einen Stimulusmagneten am Gehäuse (710) zum Erfassen einer Neigung des Tablet-Computers (102, 602, 700, 902).

4. Tablet-Computersystem nach Anspruch 1, ferner umfassend eine zusätzliche Gruppe von Magneten, die entlang einer Längsachse des Gehäuses (710) angeordnet ist, wobei die zusätzliche Gruppe von Magneten so konfiguriert ist, dass sie magnetisch mit einer dritten Vielzahl von Magneten einer alternativen Dockingstation (904) koppelt.

5. Tablet-Computersystem nach Anspruch 1, wobei jede Gruppe von Magneten zwei Magnete umfasst.

6. Tablet-Computersystem nach Anspruch 1, wobei Magnete innerhalb jeder Gruppe von Magneten in entgegengesetzten Nord- und Südpolaritäten angeordnet sind.

7. Tablet-Computersystem nach Anspruch 1, wobei Magnete innerhalb jeder Gruppe von Magneten so angeordnet sind, dass entgegengesetzte Pole zueinander ausgerichtet sind.

8. Tablet-Computer (102, 602, 700, 902), umfassend:
eine elektronische Anzeige (110);
ein Gehäuse (710), das die elektronische Anzeige (110) beherbergt; und
eine erste Vielzahl von Magneten (702), wobei die erste Vielzahl von Magneten (702) so angeordnet ist, dass sie magnetisch mit einer zweiten Vielzahl von Magneten (802) einer Dockingstation (104, 604, 800) koppelt,
wobei die erste Vielzahl von Magneten (702) in einer Anordnung ausgebildet ist, die umfasst:
wenigstens vier Gruppen von Magneten auf jeder lateralen Seite (706, 708) des Gehäuses (710), wobei:
die wenigstens vier Gruppen von Magneten auf einer ersten lateralen Seite (706) des Gehäuses (710) in einer gespiegelten Konfiguration zu den wenigstens vier Gruppen von Magneten auf einer zweiten lateralen Seite (708) des Gehäuses (710) sind,
wenigstens drei der Gruppen von Magneten (720) auf jeder lateralen Seite (706, 708) des Gehäuses (710) horizontal ausgerichtet sind und eine vierte Gruppe von Magneten (722) auf jeder lateralen Seite (706, 708) des Gehäuses (710) vertikal ausgerichtet ist, wobei die drei Gruppen von Magneten (720) auf jeder lateralen Seite (706, 708) des Gehäuses (710) eine alternierende Nord- und Südpolarität über die drei Gruppen von Magneten umfassen, und
die zwei innersten Gruppen von Magneten (724) übereinstimmende Nord- und Südpolaritäten über die zwei innersten Gruppen von Magneten umfassen.

9. Tablet-Computer (102, 602, 700, 902) nach Anspruch 8, wobei ein Spalt zwischen der ersten Vielzahl von Magneten (702) und der zweiten Vielzahl von Magneten (802) in einem Bereich von 1,65 mm bis 2,5 mm liegt, wenn der Tablet-Computer an der Dockingstation (104, 604, 800) angedockt ist.

10. Tablet-Computer (102, 602, 700, 902) nach Anspruch 8, ferner umfassend einen Stimulusmagneten am Gehäuse (710) zum Erfassen einer Neigung des Tablet-Computers (102, 602, 700, 902).

11. Tablet-Computer (102, 602, 700, 902) nach Anspruch 8, ferner umfassend eine zusätzliche Gruppe von Magneten, die entlang einer Längsachse des Gehäuses (710) angeordnet ist, wobei die zusätzliche Gruppe von Magneten so konfiguriert ist, dass sie magnetisch mit einer dritten Vielzahl von Magneten einer alternativen Dockingstation (904) koppelt.

12. Tablet-Computer (102, 602, 700, 902) nach Anspruch 8, wobei jede Gruppe von Magneten zwei Magnete umfasst.

13. Tablet-Computer (102, 602, 700, 902) nach Anspruch 8, wobei Magnete innerhalb jeder Gruppe von Magneten in entgegengesetzten Nord- und Südpolaritäten angeordnet sind.

14. Dockingstation (104, 604, 800), umfassend:
ein Dockingstationsgehäuse;
eine Frontplatte (810, 922), wobei die Frontplatte (810, 922) lösbar mit einem Tablet-Computer (102, 602, 700, 902) gekoppelt ist; und
eine zweite Vielzahl von Magneten (802), wobei die zweite Vielzahl von Magneten (802) so angeordnet ist, dass sie magnetisch mit einer ersten Vielzahl von Magneten (702) des Tablet-Computers (102, 602, 700, 902) koppelt,
wobei die zweite Vielzahl von Magneten (802) in einer Anordnung ausgebildet ist, die umfasst:
wenigstens vier Gruppen von Magneten auf jeder lateralen Seite (806, 808) der Frontplatte (810, 922), wobei:
die wenigstens vier Gruppen von Magneten auf einer ersten lateralen Seite (806) der Frontplatte (810, 922) in einer gespiegelten Konfiguration zu den wenigstens vier Gruppen von Magneten auf einer zweiten lateralen Seite (808) der Frontplatte (810, 922) sind,
wenigstens drei der Gruppen von Magneten (820) auf jeder lateralen Seite (806, 808) der Frontplatte (810, 922) horizontal ausgerichtet sind und eine vierte Gruppe von Magneten (822) auf jeder lateralen Seite (806, 808) der Frontplatte (810, 922) vertikal ausgerichtet ist, wobei die drei Gruppen von Magneten (820) auf jeder lateralen Seite (806, 808) der Frontplatte (810, 922) eine alternierende Nord- und Südpolarität über die drei Gruppen von Magneten umfassen, und
die zwei innersten Gruppen von Magneten (824) übereinstimmende Nord- und Südpolaritäten über die zwei innersten Gruppen von Magneten umfassen.

15. Dockingstation nach Anspruch 14, wobei ein Spalt zwischen der ersten Vielzahl von Magneten und der zweiten Vielzahl von Magneten in einem Bereich von 1,65 mm bis 2,5 mm liegt, wenn der Tablet-Computer an der Dockingstation angedockt ist, oder Magnete innerhalb jeder Gruppe von Magneten in entgegengesetzten Nord- und Südpolaritäten angeordnet sind.

## Revendications

1. Système de tablette informatique, comprenant :
une station d'accueil (104, 604, 800) ;
une tablette informatique (102, 602, 700, 902) qui peut être connectée de manière amovible à la station d'accueil (104, 604, 800), la tablette informatique (102, 602, 700, 902) comprenant :
un affichage électronique (110) ;
une enceinte (710) logeant l'affichage électronique (110) ; et
une première pluralité d'aimants (702), dans lequel la première pluralité d'aimants sont agencés pour se coupler magnétiquement avec une deuxième pluralité d'aimants (802) de la station d'accueil,
la première pluralité d'aimants (702) étant formée dans un agencement comprenant :
au moins quatre groupes d'aimants sur chaque côté latéral (706, 708) de l'enceinte (710), dans lequel :
les au moins quatre groupes d'aimants sur un premier côté latéral (706) de l'enceinte (710) présentent une configuration en miroir par rapport aux au moins quatre groupes d'aimants sur un second côté latéral (708) de l'enceinte (710),
au moins trois des groupes d'aimants (720) sur chaque côté latéral (706, 708) de l'enceinte (710) sont orientés horizontalement et un quatrième groupe d'aimants (722) sur chaque côté latéral (706, 708) de l'enceinte (710) est orienté verticalement, les trois groupes d'aimants (720) sur chaque côté latéral (706, 708) de l'enceinte (710) comprenant une polarité alternée nord et sud entre les trois groupes d'aimants, et
les deux groupes d'aimants les plus internes (724) comprenant des polarités nord et sud correspondantes entre les deux groupes d'aimants les plus internes.

2. Système de tablette informatique selon la revendication 1, dans lequel un écart entre la première pluralité d'aimants (702) et la deuxième pluralité d'aimants (802) est compris dans une plage allant de 1,65 mm à 2,5 mm lorsque la tablette informatique (102, 602, 700, 902) est connectée à la station d'accueil (104, 604, 800).

3. Système de tablette informatique selon la revendication 1, comprenant également un aimant de stimulation sur l'enceinte (710) pour détecter l'inclinaison de la tablette informatique (102, 602, 700, 902).

4. Système de tablette informatique selon la revendication 1, comprenant également un groupe supplémentaire d'aimants disposés le long d'un axe longitudinal de l'enceinte (710), le groupe supplémentaire d'aimants étant configuré pour se coupler magnétiquement avec une troisième pluralité d'aimants d'une station d'accueil alternative (904).

5. Système de tablette informatique selon la revendication 1, dans lequel chaque groupe d'aimants comprend deux aimants.

6. Système de tablette informatique selon la revendication 1, dans lequel des aimants au sein de chaque groupe d'aimants sont agencés en polarités nord et sud opposées.

7. Système de tablette informatique selon la revendication 1, dans lequel des aimants au sein de chaque groupe d'aimants sont agencés de sorte que les pôles opposés sont orientés l'un vers l'autre.

8. Tablette informatique (102, 602, 700, 902), comprenant :
un affichage électronique (110) ;
une enceinte (710) logeant l'affichage électronique (110) ; et
une première pluralité d'aimants (702), dans laquelle la première pluralité d'aimants (702) sont agencés pour se coupler magnétiquement avec une deuxième pluralité d'aimants (802) d'une station d'accueil (104, 604, 800),
la première pluralité d'aimants (702) étant formée dans un agencement comprenant :
au moins quatre groupes d'aimants sur chaque côté latéral (706, 708) de l'enceinte (710), dans laquelle :
les au moins quatre groupes d'aimants sur un premier côté latéral (706) de l'enceinte (710) présentent une configuration en miroir par rapport aux au moins quatre groupes d'aimants sur un second côté latéral (708) de l'enceinte (710),
au moins trois des groupes d'aimants (720) sur chaque côté latéral (706, 708) de l'enceinte (710) sont orientés horizontalement et un quatrième groupe d'aimants (722) sur chaque côté latéral (706, 708) de l'enceinte (710) est orienté verticalement, les trois groupes d'aimants (720) sur chaque côté latéral (706, 708) de l'enceinte (710) comprenant une polarité alternée nord et sud entre les trois groupes d'aimants, et
les deux groupes d'aimants les plus internes (724) comprenant des polarités nord et sud correspondantes entre les deux groupes d'aimants les plus internes.

9. Tablette informatique (102, 602, 700, 902) selon la revendication 8, dans laquelle un écart entre une première pluralité d'aimants (702) et la deuxième pluralité d'aimants (802) est compris dans une plage allant de 1,65 mm à 2,5 mm lorsque la tablette informatique est connectée à la station d'accueil (104, 604, 800).

10. Tablette informatique (102, 602, 700, 902) selon la revendication 8, comprenant également un aimant de stimulation sur l'enceinte (710) pour détecter l'inclinaison de la tablette informatique (102, 602, 700, 902).

11. Tablette informatique (102, 602, 700, 902) selon la revendication 8, comprenant également un groupe supplémentaire d'aimants disposés le long d'un axe longitudinal de l'enceinte (710), le groupe supplémentaire d'aimants étant configuré pour se coupler magnétiquement avec une troisième pluralité d'aimants d'une station d'accueil alternative (904).

12. Tablette informatique (102, 602, 700, 902) selon la revendication 8, dans laquelle chaque groupe d'aimants comprend deux aimants.

13. Tablette informatique (102, 602, 700, 902) selon la revendication 8, dans laquelle des aimants au sein de chaque groupe d'aimants sont agencés en polarités nord et sud opposées.

14. Station d'accueil (104, 604, 800), comprenant :
un boîtier de station d'accueil ;
une plaque frontale (810, 922), la plaque frontale (810, 922) étant couplée de manière amovible à une tablette informatique (102, 602, 700, 902) ; et
une deuxième pluralité d'aimants (802), dans laquelle la deuxième pluralité d'aimants (802) sont agencés pour se coupler magnétiquement avec une première pluralité d'aimants (702) de la tablette informatique (102, 602, 700, 902),
la deuxième pluralité d'aimants (802) étant formée dans un agencement comprenant :
au moins quatre groupes d'aimants sur chaque côté latéral (806, 808) de la plaque frontale (810, 922), dans laquelle :
les au moins quatre groupes d'aimants sur un premier côté latéral (806) de la plaque frontale (810, 922) présentent une configuration en miroir par rapport aux au moins quatre groupes d'aimants sur un second côté latéral (808) de la plaque frontale (810, 922),
au moins trois des groupes d'aimants (820) sur chaque côté latéral (806, 808) de la plaque frontale (810, 922) sont orientés horizontalement et un quatrième groupe d'aimants (822) sur chaque côté latéral (806, 808) de la plaque frontale (810, 922) est orienté verticalement, les trois groupes d'aimants (820) sur chaque côté latéral (806, 808) de la plaque frontale (810, 922) comprenant une polarité alternée nord et sud entre les trois groupes d'aimants, et
les deux groupes d'aimants les plus internes (824) comprenant des polarités nord et sud correspondantes entre les deux groupes d'aimants les plus internes.

15. Station d'accueil selon la revendication 14, dans laquelle un écart entre une première pluralité d'aimants et la deuxième pluralité d'aimants est compris dans une plage allant de 1,65 mm à 2,5 mm lorsque la tablette informatique est connectée à la station d'accueil ou lorsque des aimants au sein de chaque groupe d'aimants sont agencés en polarités nord et sud opposées.
